(19) Europäisches Patentamt
European Patent Office
Office européen des brevets

(11) EP 4 151 687 B1

(12) **EUROPEAN PATENT SPECIFICATION**

(45) Date of publication and mention of the grant of the patent:
**29.11.2023 Bulletin 2023/48**

(21) Application number: **21197791.3**

(22) Date of filing: **20.09.2021**

(51) International Patent Classification (IPC):
***C08L 71/12*** *(2006.01)*

(52) Cooperative Patent Classification (CPC):
(C-Sets available)
**C08L 71/12** (Cont.)

(54) **METALLIZED ARTICLE AND ASSOCIATED POLY(PHENYLENE ETHER) COMPOSITION AND INJECTION-MOLDED ARTICLE**

METALLISIERTER GEGENSTAND UND DAMIT VERBUNDENE POLY(PHENYLENETHER)ZUSAMMENSETZUNG UND SPRITZGEGOSSENER ARTIKEL

ARTICLE MÉTALLISÉ ET COMPOSITION DE POLY(PHÉNYLÈNE ÉTHER) ET ARTICLE MOULÉ PAR INJECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.03.2023 Bulletin 2023/12**

(73) Proprietor: **SHPP Global Technologies B.V.**
**4612 PX Bergen op Zoom (NL)**

(72) Inventors:
- **Chen, Haiming**
  **Shanghai (CN)**
- **Gan, Haiyang**
  **Shanghai (CN)**
- **Mao, Rui**
  **Shanghai (CN)**
- **Park, Hyemin (Mark)**
  **Yongin-city (KR)**

(74) Representative: **Balder IP Law, S.L.**
**Paseo de la Castellana 93**
**5ª planta**
**28046 Madrid (ES)**

(56) References cited:
**EP-B1- 3 546 509** **US-A1- 2012 214 929**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 151 687 B1

(52) Cooperative Patent Classification (CPC): (Cont.)

C-Sets

**C08L 71/12, C08L 25/06, C08L 25/08, C08L 71/12;**
**C08L 71/12, C08L 25/06, C08L 71/12**

## Description

BACKGROUND OF THE INVENTION

Reduced weight and reduced cost are key drivers for innovation in the automotive industry, especially for electric vehicles. Heat-resistant polycarbonates are currently used in the fabrication of reflective articles for automotive reflectors and bezels. The heat-resistant polycarbonates are used to injection mold articles with a smooth surface suitable for metal deposition, and the resulting reflective articles exhibit an excellent balance of heat resistance, surface smoothness, low water absorption, low outgassing, and good metal adhesion, all at a weight that is much less than that of predecessor articles prepared from metal alone. Nevertheless, there is a desire for reflective articles that are lighter and lower-cost while exhibiting increased tensile stress at yield, increased flexural strength, and reduced water absorption, and while being at least comparable in flexural modulus, heat deflection temperature, and mold shrinkage.
EP3546509B1 discloses filled polymer resin compositions including a thermally conductive filler and a dielectric ceramic filler.

BRIEF SUMMARY OF EMBODIMENTS OF THE INVENTION

One embodiment is a reflective article comprising: an injection molded thermoplastic substrate; and a reflective metal layer disposed on a surface of the thermoplastic substrate; wherein the injection molded thermoplastic substrate comprises a melt-blended composition comprising the product of melt-blending a pre-blended composition comprising, based on the total weight of the pre-blended composition, 40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_{n1}$, and a first dispersity, $M_w1/M_n1$, determined according to ASTM D5296-19 using gel permeation chromatography with polystyrene standards; 5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards; 5 to 25 weight percent of an atactic polystyrene; and 0 to 10 weight percent of a hydrogenated block copolymer of an alkenyl aromatic compound and a conjugated diene; wherein a blend of the 40 to 90 weight percent of the first poly(phenylene ether) and the 5 to 25 weight percent of the second poly(phenylene ether) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

Another embodiment is a melt-blended composition comprising the product of melt-blending a pre-blended composition comprising, based on the total weight of the pre-blended composition: 40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_{n1}$, and a first dispersity, $M_w1/M_n1$, determined according to ASTM D5296-19 using gel permeation chromatography with polystyrene standards; 5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards; 5 to 25 weight percent of an atactic polystyrene; and 0 to 10 weight percent of a hydrogenated block copolymer of an alkenyl aromatic compound and a conjugated diene; wherein a blend of the 40 to 90 weight percent of the first poly(phenylene ether) and the 5 to 25 weight percent of the second poly(phenylene ether) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

Another embodiment is an injection molded article comprising the melt-blended composition in any of the

variations described herein.

These and other embodiments are described in detail below.

BRIEF DESCRIPTION OF THE DRAWINGS

The Figure is an exploded schematic illustration of a reflective article 10 comprising an injection molded thermoplastic substrate 20, and a reflective metal layer 30 disposed on a surface of the thermoplastic substrate.

DETAILED DESCRIPTION OF THE INVENTION

The present inventors have determined that a specific poly(phenylene ether)-based composition comprising two poly(phenylene ether)s of different intrinsic viscosities and optionally comprising a specific amount of a carboxylic acid and/or carboxylic acid anhydride can be used to injection mold substrates that, when metallized to form reflective articles, are lighter and lower-cost than comparable polycarbonate-based reflective articles, while exhibiting increased tensile stress at yield, increased flexural strength, and reduced water absorption, and while being at least comparable in flexural modulus, heat deflection temperature, and mold shrinkage.

Thus, one embodiment is a reflective article comprising: an injection molded thermoplastic substrate; and a reflective metal layer disposed on a surface of the thermoplastic substrate; wherein the injection molded thermoplastic substrate comprises a melt-blended composition comprising the product of melt-blending a pre-blended composition comprising, based on the total weight of the pre-blended composition, 40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_{n1}$, and a first dispersity, $M_w1/M_n1$, determined according to ASTM D5296-19 using gel permeation chromatography with polystyrene standards; 5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards; 5 to 25 weight percent of an atactic polystyrene; and 0 to 10 weight percent of a hydrogenated block copolymer of an alkenyl aromatic compound and a conjugated diene; wherein a blend of the 40 to 90 weight percent of the first poly(phenylene ether) and the 5 to 25 weight percent of the second poly(phenylene ether) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

The pre-blended composition comprises a first poly(phenylene ether) and a second poly(phenylene ether). In general, poly(phenylene ether)s are polymers comprising repeating structural units having the formula

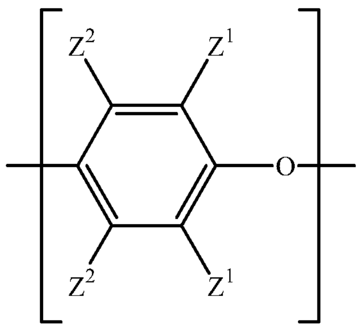

wherein each occurrence of $Z^1$ is independently halogen, unsubstituted or substituted $C_1$-$C_{12}$ hydrocarbyl provided that the hydrocarbyl group is not tertiary hydrocarbyl, $C_1$-$C_{12}$ hydrocarbylthio, $C_1$-$C_{12}$ hydrocarbyloxy, or $C_2$-$C_{12}$ halohydrocarbyloxy wherein at least two carbon atoms separate the halogen and oxygen atoms; and each occurrence of $Z^2$ is independently hydrogen, halogen, unsubstituted or substituted $C_1$-$C_{12}$ hydrocarbyl provided that the hydrocarbyl group is not tertiary hydrocarbyl, $C_1$-$C_{12}$ hydrocarbylthio, $C_1$-$C_{12}$ hydrocarbyloxy, or $C_2$-$C_{12}$ halohydrocarbyloxy wherein at least two carbon atoms separate the halogen and oxygen atoms. As used herein, the term "hydrocarbyl", whether used

by itself, or as a prefix, suffix, or fragment of another term, refers to a residue that contains only carbon and hydrogen. The residue can be aliphatic or aromatic, straight-chain, cyclic, bicyclic, branched, saturated, or unsaturated. It can also contain combinations of aliphatic, aromatic, straight chain, cyclic, bicyclic, branched, saturated, and unsaturated hydrocarbon moieties. However, when the hydrocarbyl residue is described as substituted, it may, optionally, contain heteroatoms over and above the carbon and hydrogen members of the substituent residue. Thus, when specifically described as substituted, the hydrocarbyl residue can also contain one or more carbonyl groups, amino groups, hydroxyl groups, or the like, or it can contain heteroatoms within the backbone of the hydrocarbyl residue. As one example, $Z^1$ can be a di-n-butylaminomethyl group formed by reaction of a terminal 3,5-dimethyl-1,4-phenyl group with the di-n-butylamine component of an oxidative polymerization catalyst.

The poly(phenylene ether) can comprise molecules having aminoalkyl-containing end group(s), typically located in a position ortho to the hydroxyl group. Also frequently present are tetramethyldiphenoquinone (TMDQ) end groups, typically obtained from 2,6-dimethylphenol-containing reaction mixtures in which tetramethyldiphenoquinone by-product is present. The poly(phenylene ether) can be in the form of a homopolymer, a copolymer, a graft copolymer, an ionomer, or a block copolymer, as well as combinations thereof.

In some embodiments, the poly(phenylene ether) comprises a poly(phenylene ether)-polysiloxane block copolymer. As used herein, the term "poly(phenylene ether)-polysiloxane block copolymer" refers to a block copolymer comprising at least one poly(phenylene ether) block and at least one polysiloxane block.

In some embodiments, the poly(phenylene ether)-polysiloxane block copolymer is prepared by an oxidative copolymerization method. In this method, the poly(phenylene ether)-polysiloxane block copolymer is the product of a process comprising oxidatively copolymerizing a monomer mixture comprising a monohydric phenol and a hydroxyaryl-terminated polysiloxane. In some embodiments, the monomer mixture comprises 70 to 99 parts by weight of the monohydric phenol and 1 to 30 parts by weight of the hydroxyaryl-terminated polysiloxane, based on the total weight of the monohydric phenol and the hydroxyaryl-terminated polysiloxane. The hydroxyaryl-diterminated polysiloxane can comprise a plurality of repeating units having the structure

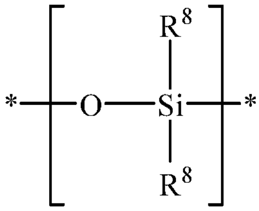

wherein each occurrence of $R^8$ is independently hydrogen, $C_1$-$C_{12}$ hydrocarbyl or $C_1$-$C_{12}$ halohydrocarbyl; and two terminal units having the structure

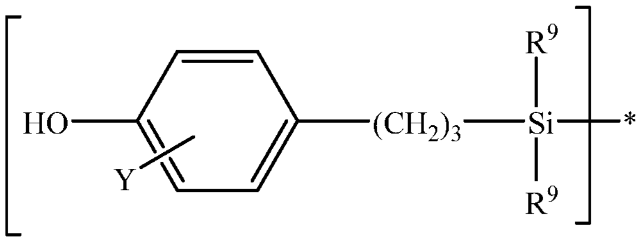

wherein Y is hydrogen, $C_1$-$C_{12}$ hydrocarbyl, $C_1$-$C_{12}$ hydrocarbyloxy, or halogen, and wherein each occurrence of $R^9$ is independently hydrogen, $C_1$-$C_{12}$ hydrocarbyl or $C_1$-$C_{12}$ halohydrocarbyl. In a very specific embodiment, each occurrence of $R^8$ and $R^9$ is methyl, and Y is methoxyl.

In some embodiments, the monohydric phenol comprises 2,6-dimethylphenol, and a hydroxyaryl-terminated polysiloxane having the structure

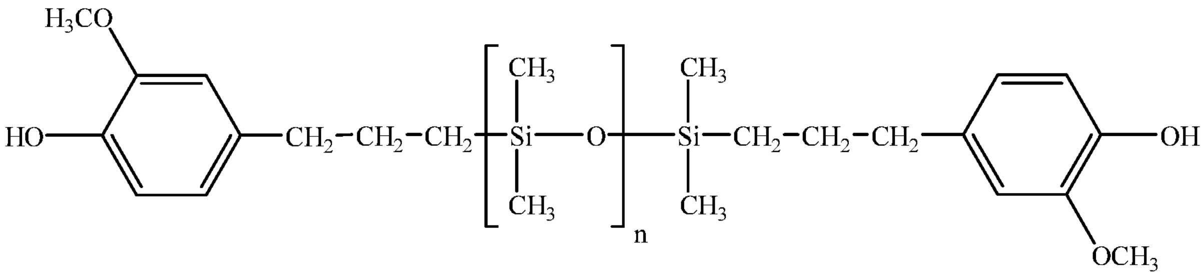

wherein n is, on average, 5 to 100, specifically 30 to 60.

The oxidative copolymerization method produces poly(phenylene ether)-polysiloxane block copolymer as the desired product and poly(phenylene ether) (without an incorporated polysiloxane block) as a by-product. It is not necessary to separate the poly(phenylene ether) from the poly(phenylene ether)-polysiloxane block copolymer. The poly(phenylene ether)-polysiloxane block copolymer can thus be utilized as a "reaction product" that includes both the poly(phenylene ether) and the poly(phenylene ether)-polysiloxane block copolymer. Certain isolation procedures, such as precipitation from isopropanol, make it possible to assure that the reaction product is essentially free of residual hydroxyaryl-terminated polysiloxane starting material. In other words, these isolation procedures assure that the polysiloxane content of the reaction product is essentially all in the form of poly(phenylene ether)-polysiloxane block copolymer. Detailed methods for forming poly(phenylene ether)-polysiloxane block copolymers are described in U.S. Patent No. 8,017,697 to Carrillo et al., and U.S. Patent Application Publication No. US 2012/0329961 A1 of Carrillo et al.

In some embodiments, the first poly(phenylene ether) and the second poly(phenylene ether) each comprise a poly(2,6-dimethyl-1,4-phenylene ether). In some embodiments, one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer.

The first poly(phenylene ether) has an intrinsic viscosity of 0.3 to 0.43 deciliter/gram, determined in chloroform at 23°C by Ubbelohde viscometer. Within this range, the intrinsic viscosity of the first poly(phenylene ether) can be 0.35 to 0.43 deciliter/gram, or 0.37 to 0.43 deciliter/gram. The first poly(phenylene ether) also has a first weight average molecular weight, $M_w1$, a first number average molecular weight, $M_{n1}$, and a first dispersity, $M_w1/M_n1$, determined according to ASTM D5296-19 using gel permeation chromatography with polystyrene standards.

The second poly(phenylene ether) has an intrinsic viscosity of greater than 0.43 to 0.49 deciliter/gram, determined in chloroform at 23°C by Ubbelohde viscometer. Within this range, the intrinsic viscosity of the first poly(phenylene ether) can be 0.43 to 0.49 deciliter/gram.

The intrinsic viscosity of the second poly(phenylene ether) is 0.03 to 0.09 deciliter/gram greater than the intrinsic viscosity of the first poly(phenylene ether). Within this range, the intrinsic viscosity of the second poly(phenylene ether) can be 0.04 to 0.08 deciliter/gram greater than the intrinsic viscosity of the first poly(phenylene ether).

The second poly(phenylene ether) also has a second weight average molecular weight, $M_w2$, a second number average molecular weight, $M_n2$, and a second dispersity, $M_w2/M_n2$, determined according to ASTM D5296-19 using gel permeation chromatography with polystyrene standards.

The pre-blended composition comprises 40 to 90 weight percent of the first poly(phenylene ether), based on the total weight of the pre-blended composition. Within this range, the amount of the first poly(phenylene ether) can be 60 to 80 weight percent, or 65 to 75 weight percent.

The pre-blended composition comprises 5 to 25 weight percent of the second poly(phenylene ether), based on the total weight of the pre-blended composition. Within this range, the amount of the first poly(phenylene ether) can be 7 to 20 weight percent, or 8 to 16 weight percent, or 10 to 20 weight percent.

A blend of the 40 to 90 weight percent of the first poly(phenylene ether) and the 5 to 25 weight percent of the second poly(phenylene ether) (i.e., a blend consisting of 40 to 90 parts by weight of the first poly(phenylene ether) and 5 to 25 parts by weight percent of the second poly(phenylene ether)) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards. The blend dispersity, $M_w$blend, is greater than the first dispersity, $M_w1/M_n1$, and less than the second dispersity, $M_w2/M_n2$.

In some embodiments, the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Within the range of 30,000 to 47,000 grams/mole, the first weight average molecular weight, $M_w1$, can be 35,000 to 47,000 grams/mole, or 40,000 to 47,000 grams/mole, or 42,000 to 47,000 grams/mole. Within the range of 15,000 to 24,000 grams/mole, the first number average molecular weight, $M_{n1}$, can be 16,000 to 23,000 grams/mole, or 17,000 to 22,000 grams/mole. Within the range of 2.0 to 2.45, the first dispersity, $M_w1/M_n1$, can be 2.1 to 2.45, or 2.2 to 2.45. Within the range of 47,000 to 65,000 grams/mole, the second weight average molecular weight, $M_w2$, can be 47,000 to 60,000 grams/mole, or 48,000 to 55,000 grams/mole, or 48,000 to 53,000 grams/mole. Within the range of 15,000 to 24,000 grams/mole, the second number average molecular weight, $M_n2$, can be 16,000 to 23,000 grams/mole, or 17,000 to 22,000 grams/mole. Within the range of 2.45 to 3.00, the second dispersity, $M_w2/M_n2$, can be 2.5 to 2.9, or 2.5 to 2.7. Within the range of 3 1,000 to 65,000 grams/mole, the blend weight average molecular weight, $M_w$blend, can be 31,000 to 60,000 grams/mole, or 35,000 to 60,000 grams/mole, or 40,000 to 55,000 grams/mole, or 40,000 to 52,000 grams/mole. Within the range of 13,000 to 25,000 grams/mole, the blend number average molecular weight, $M_n$blend, can be 15,000 to 24,000 grams/mole, or 16,000 to 23,000 grams/mole. Within the range of 2.1 to 2.55, the blend dispersity, $M_w$blend/$M_n$blend, can be 2.25 to 2.55, or 2.35 to 2.55, or 2.37 to 2.53.

In addition to the first poly(phenylene ether) and the second poly(phenylene ether), the pre-blended composition comprises an atactic polystyrene. In some embodiments, the atactic polystyrene has a melt flow index of 2 to 25 grams/10 minutes, determined according to ASTM D1238-20 at 200 °C and 5 kilograms load. Within this range, the melt flow index of the atactic polystyrene can be 5 to 20 grams/10 minutes, or 5 to 15 grams/10 minutes. The pre-blended composition comprises 5 to 25 weight percent of the atactic polystyrene, based on the total weight of the pre-blended composition. Within this range, the amount of the atactic polystyrene can be 10 to 20 weight percent.

The pre-blended composition can, optionally, further include a hydrogenated block copolymer of an alkenyl aromatic compound and a conjugated diene. For brevity, this component is referred to as the "hydrogenated block copolymer". The hydrogenated block copolymer may comprise about 10 to about 90 weight percent of poly(alkenyl aromatic) content and about 90 to about 10 weight percent of hydrogenated poly(conjugated diene) content, based on the weight of the hydrogenated block copolymer. In some embodiments, the poly(alkenyl aromatic) content is about 10 to about 45 weight percent, or about 20 to about 40 weight percent, or about 25 to about 35 weight percent. In other embodiments, the poly(alkenyl aromatic) content is about 45 weight percent to about 90 weight percent, or about 45 to about 80 weight percent. The hydrogenated block copolymer can have a weight average molecular weight of about 40,000 to about 400,000 atomic mass units. The number average molecular weight and the weight average molecular weight may be determined by gel permeation chromatography and based on comparison to polystyrene standards. In some embodiments, the hydrogenated block copolymer has a weight average molecular weight of about 200,000 to about 400,000 atomic mass units, or about 220,000 to about 350,000 atomic mass units. In other embodiments, the hydrogenated block copolymer can have a weight average molecular weight of about 40,000 to about 200,000 atomic mass units, or about 40,000 to about 180,000 atomic mass units, or about 40,000 to about 150,000 atomic mass units.

The alkenyl aromatic monomer used to prepare the hydrogenated block copolymer can have the structure

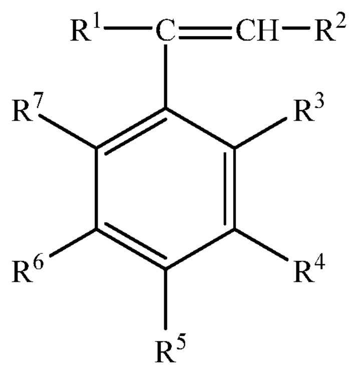

wherein $R^1$ and $R^2$ each independently represent a hydrogen atom, a $C_1$-$C_8$ alkyl group, or a $C_2$-$C_8$ alkenyl group; $R^3$ and $R^7$ each independently represent a hydrogen atom, a $C_1$-$C_8$ alkyl group, a chlorine atom, or a bromine atom; and $R^4$, $R^5$, and $R^6$ each independently represent a hydrogen atom, a $C_1$-$C_8$ alkyl group, or a $C_2$-$C_8$ alkenyl group, or $R^4$ and $R^5$ are taken together with the central aromatic ring to form a naphthyl group, or $R^5$ and $R^6$are taken together with the central aromatic ring to form a naphthyl group. Specific alkenyl aromatic monomers include, for example, styrene, chlorostyrenes such as p-chlorostyrene, and methylstyrenes such as alpha-methylstyrene and p-methylstyrene. In some embodiments, the alkenyl aromatic monomer is styrene.

The conjugated diene used to prepare the hydrogenated block copolymer can be a $C_4$-$C_{20}$ conjugated diene. Suitable conjugated dienes include, for example, 1,3-butadiene, 2-methyl-1,3-butadiene, 2-chloro-1,3-butadiene, 2,3-dimethyl-1,3-butadiene, 1,3-pentadiene, 1,3-hexadiene, and the like, and combinations thereof. In some embodiments,

the conjugated diene is 1,3-butadiene, 2-methyl-1,3-butadiene, or a combination thereof. In some embodiments, the conjugated diene consists of 1,3-butadiene.

The hydrogenated block copolymer is a copolymer comprising (A) at least one block derived from an alkenyl aromatic compound and (B) at least one block derived from a conjugated diene, in which the aliphatic unsaturated group content in the block (B) is at least partially reduced by hydrogenation. In some embodiments, the aliphatic unsaturation in the (B) block is reduced by at least 50 percent, or at least 70 percent. The arrangement of blocks (A) and (B) includes a linear structure, a grafted structure, and a radial teleblock structure with or without a branched chain. Linear block copolymers include tapered linear structures and non-tapered linear structures. In some embodiments, the hydrogenated block copolymer has a tapered linear structure. In some embodiments, the hydrogenated block copolymer has a non-tapered linear structure. In some embodiments, the hydrogenated block copolymer comprises a B block that comprises random incorporation of alkenyl aromatic monomer. Linear block copolymer structures include diblock (A-B block), triblock (A-B-A block or B-A-B block), tetrablock (A-B-A-B block), and pentablock (A-B-A-B-A block or B-A-B-A-B block) structures as well as linear structures containing six or more blocks in total of A and B, wherein the molecular weight of each A block may be the same as or different from that of other A blocks, and the molecular weight of each B block may be the same as or different from that of other B blocks. In some embodiments, the hydrogenated block copolymer is a diblock copolymer, a triblock copolymer, or a combination thereof.

In some embodiments, the hydrogenated block copolymer excludes the residue of monomers other than the alkenyl aromatic compound and the conjugated diene.

In some embodiments, the hydrogenated block copolymer comprises a polystyrene-poly(ethylene-butylene)-polystyrene triblock copolymer. In some embodiments, the hydrogenated block copolymer comprises a polystyrene-poly(ethylene-butylene)-polystyrene triblock copolymer having a weight average molecular weight of about 200,000 to about 400,000 atomic mass units, or about 240,000 to about 350,000 atomic mass units, or about 240,000 to about 300,000 atomic mass units.

Methods for preparing hydrogenated block copolymers are known in the art and many hydrogenated block copolymers are commercially available. Illustrative commercially available hydrogenated block copolymers include the polystyrene-poly(ethylene-propylene) diblock copolymers available from Kraton Polymers as KRATON G1701 and G1702; the polystyrene-poly(ethylene-butylene)-polystyrene triblock copolymers available from Kraton Polymers as KRATON G1641, G1650, G1651, G1654, G1657, G1726, G4609, G4610, GRP-6598, RP-6924, MD-6932M, MD-6933, and MD-6939; the polystyrene-poly(ethylenebutylene-styrene)-polystyrene (S-EB/S-S) triblock copolymers available from Kraton Polymers as KRATON RP-6935 and RP-6936, the polystyrene-poly(ethylene-propylene)-polystyrene triblock copolymers available from Kraton Polymers as KRATON G1730; the maleic anhydride-grafted polystyrene-poly(ethylene-butylene)-polystyrene triblock copolymers available from Kraton Polymers as KRATON G1901, G1924, and MD-6684; the maleic anhydride-grafted polystyrene-poly(ethylene-butylene-styrene)-polystyrene triblock copolymer available from Kraton Polymers as KRATON MD-6670; the polystyrene-poly(ethylene-butylene)-polystyrene triblock copolymer comprising 67 weight percent polystyrene available from Asahi Kasei Elastomer as TUFTEC H1043; the polystyrene-poly(ethylene-butylene)-polystyrene triblock copolymer comprising 42 weight percent polystyrene available from Asahi Kasei Elastomer as TUFTEC H1051; the polystyrene-poly(butadiene-butylene)-polystyrene triblock copolymers available from Asahi Kasei Elastomer as TUFTEC P1000 and P2000; the polystyrene-polybutadiene-poly(styrene-butadiene)-polystyrene block copolymer available from Asahi Kasei Elastomer as S.O.E.-SS L601; the hydrogenated radial block copolymers available from Chevron Phillips Chemical Company as K-Resin KK38, KR01, KR03, and KR05; the polystyrene-poly(ethylene-butylene)-polystyrene triblock copolymer comprising 60 weight polystyrene available from Kuraray as SEPTON S8104; the polystyrene-poly(ethylene-ethylene/propylene)-polystyrene triblock copolymers available from Kuraray as SEPTON S4044, S4055, S4077, and S4099; and the polystyrene-poly(ethylene-propylene)-polystyrene triblock copolymer comprising 65 weight percent polystyrene available from Kuraray as SEPTON S2104. Mixtures of two of more hydrogenated block copolymers can be used.

The pre-blended composition comprises 0 to 10 weight percent of the hydrogenated block copolymer, based on the total weight of the pre-blended composition. Within this range, the amount of the hydrogenated block copolymer can be 1 to 10 weight percent, or 2 to 10 weight percent.

The sum of the weight percents of the first poly(phenylene ether), the second poly(phenylene ether), the atactic polystyrene, and the hydrogenated block copolymer is 95 to 100 weight percent, based on the total weight of the pre-blended composition. Within this range, the sum of the weight percents of the first poly(phenylene ether), the second poly(phenylene ether), the atactic polystyrene, and the hydrogenated block copolymer can be 96 to 100 weight percent, or 97 to 100 weight percent, or 98 to 100 weight percent, or 99 to 100 weight percent.

The pre-blended composition can, optionally, further comprise a carboxylic acid or carboxylic acid anhydride selected from the group consisting of citric acid, fumaric acid, maleic acid, maleic anhydride, formic acid, and combinations thereof. As demonstrated in the working examples below, use of a small amount of a carboxylic acid and/or carboxylic acid anhydride can improve metal layer adhesion in the reflective article, without creating unacceptable outgassing. In some embodiments, carboxylic acid and/or carboxylic acid anhydride comprises citric acid. When present, carboxylic

acid and/or carboxylic acid anhydride can be used in an amount of 0.3 to 1.6 weight percent, based on the total weight of the pre-blended composition. Within this range, the amount can be 0.4 to 1.2 weight percent. When the carboxylic acid and/or carboxylic acid anhydride is present, the sum of the weight percents of the first poly(phenylene ether), the second poly(phenylene ether), the atactic polystyrene, the hydrogenated block copolymer, and the carboxylic acid or carboxylic acid anhydride is 95.3 to 100 weight percent. Within this range, the sum of the weight percents of the first poly(phenylene ether), the second poly(phenylene ether), the atactic polystyrene, the hydrogenated block copolymer, and the carboxylic acid and/or carboxylic acid anhydride can be 96 to 100 weight percent, or 97 to 100 weight percent, or 98 to 100 weight percent, or 99 to 100 weight percent.

In a very specific embodiment of the reflective article, the pre-blended composition comprises 65 to 75 weight percent of the first poly(phenylene ether), 10 to 20 weight percent of the second poly(phenylene ether), 10 to 20 weight percent of the atactic polystyrene, and 0 to 10 weight percent of the hydrogenated block copolymer of an alkenyl aromatic compound and a conjugated diene; wherein the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether) and the other of the first and second poly(phenylene ether)s comprises a poly(phenylene ether)-polysiloxane block copolymer; and wherein the sum of the weight percents of the first poly(phenylene ether), the second poly(phenylene ether), the atactic polystyrene, and the hydrogenated block copolymer is 97 to 100 weight percent. Within the range of 97 to 100 weight percent, the sum of the weight percents of the first poly(phenylene ether), the second poly(phenylene ether), the atactic polystyrene, and the hydrogenated block copolymer can be 98 to 100 weight percent, or 99 to 100 weight percent. In a variation of the very specific embodiment, the first poly(phenylene ether) and the second poly(phenylene ether) each comprise a poly(2,6-dimethyl-1,4-phenylene ether). In another variation of the very specific embodiment, one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer. In another variation of the very specific embodiment, the pre-blended composition comprises 1 to 10 weight percent of the hydrogenated block copolymer, based on the total weight of the pre-blended composition. In another variation of the very specific embodiment, the pre-blended composition further comprises 0.3 to 1.6 weight percent of citric acid, based on the total weight of the pre-blended composition, and the sum of the weight percents of the first poly(phenylene ether), the second poly(phenylene ether), the atactic polystyrene, the hydrogenated block copolymer, and the citric acid is 97.3 to 100 weight percent, based on the total weight of the pre-blended composition. Within the range of 0.3 to 1.6 weight percent, the citric acid amount can be 0.4 to 1.2 weight percent. Within the range of 97.3 to 100 weight percent, the sum of the weight percents of the first poly(phenylene ether), the second poly(phenylene ether), the atactic polystyrene, the hydrogenated block copolymer, and the citric acid can be 98 to 100 weight percent, or 99 to 100 weight percent.

In another variation of the very specific embodiment, the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Within the range of 30,000 to 47,000 grams/mole, the first weight average molecular weight, $M_w1$, can be 35,000 to 47,000 grams/mole, or 40,000 to 47,000 grams/mole, or 42,000 to 47,000 grams/mole. Within the range of 15,000 to 24,000 grams/mole, the first number average molecular weight, $M_{n1}$, can be 16,000 to 23,000 grams/mole, or 17,000 to 22,000 grams/mole. Within the range of 2.0 to 2.45, the first dispersity, $M_w1/M_n1$, can be 2.1 to 2.45, or 2.2 to 2.45. Within the range of 47,000 to 65,000 grams/mole, the second weight average molecular weight, $M_w2$, can be 47,000 to 60,000 grams/mole, or 48,000 to 55,000 grams/mole, or 48,000 to 53,000 grams/mole. Within the range of 15,000 to 24,000 grams/mole, the second number average molecular weight, $M_n2$, can be 16,000 to 23,000 grams/mole, or 17,000 to 22,000 grams/mole. Within the range of 2.45 to 3.00, the second dispersity, $M_w2/M_n2$, can be 2.5 to 2.9, or 2.5 to 2.7. Within the range of 3 1,000 to 65,000 grams/mole, the blend weight average molecular weight, $M_w$blend, can be 31,000 to 60,000 grams/mole, or 35,000 to 60,000 grams/mole, or 40,000 to 55,000 grams/mole, or 40,000 to 52,000 grams/mole. Within the range of 13,000 to 25,000 grams/mole, the blend number average molecular weight, $M_n$blend, can be 15,000 to 24,000 grams/mole, or 16,000 to 23,000 grams/mole. Within the range of 2.1 to 2.55, the blend dispersity, $M_w$blend/$M_n$blend, can be 2.25 to 2.55, or 2.35 to 2.55, or 2.37 to 2.53.

The injection molded thermoplastic substrate comprises a melt-blended composition comprising the product of melt-blending the pre-blended composition. Melt blending can be conducted, for example, on a single-screw or twin-screw extruder. An example of suitable conditions for melt-blending is included in the working examples below.

The thermoplastic substrate is formed by injection molding the melt-blended composition. Methods of and apparatus for injection molding are known in the art. An example of suitable conditions for injection molding is included in the working examples below.

The reflective article comprises the injection molded thermoplastic substrate, and a reflective metal layer disposed on a surface of the thermoplastic substrate. The Figure is an exploded schematic illustration of a reflective article 10 comprising an injection molded thermoplastic substrate 20, and a reflective metal layer 30 disposed on a surface of the thermoplastic substrate. The reflective metal layer can be formed on the surface of the thermoplastic substrate using methods known in the art, including sputtering, vacuum metal deposition, vapor arc deposition, plasma chemical vapor deposition, thermal vapor metal deposition, and ion plating.

The reflective article has many possible uses, including automotive headlight reflectors, automotive bezels, automotive head up display reflectors, automotive interior parts, home appliance lighting reflectors, home appliance bezels, consumer electronics lighting reflectors, and consumer electronics bezels. In some embodiments, the reflective article is an automotive headlight reflector.

Another embodiment is a melt-blended composition comprising the product of melt-blending a pre-blended composition comprising, based on the total weight of the pre-blended composition: 40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_{n1}$, and a first dispersity, $M_w1/M_n1$, determined according to ASTM D5296-19 using gel permeation chromatography with polystyrene standards; 5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards; 5 to 25 weight percent of an atactic polystyrene; and 0 to 10 weight percent of a hydrogenated block copolymer of an alkenyl aromatic compound and a conjugated diene; wherein a blend of the 40 to 90 weight percent of the first poly(phenylene ether) and the 5 to 25 weight percent of the second poly(phenylene ether) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

All of the variations of the pre-blended composition described above in the context of the reflective article apply as well to the melt-blended composition.

In some embodiments of the melt-blended composition, the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Within the range of 30,000 to 47,000 grams/mole, the first weight average molecular weight, $M_w1$, can be 35,000 to 47,000 grams/mole, or 40,000 to 47,000 grams/mole, or 42,000 to 47,000 grams/mole. Within the range of 15,000 to 24,000 grams/mole, the first number average molecular weight, $M_{n1}$, can be 16,000 to 23,000 grams/mole, or 17,000 to 22,000 grams/mole. Within the range of 2.0 to 2.45, the first dispersity, $M_w1/M_n1$, can be 2.1 to 2.45, or 2.2 to 2.45. Within the range of 47,000 to 65,000 grams/mole, the second weight average molecular weight, $M_w2$, can be 47,000 to 60,000 grams/mole, or 48,000 to 55,000 grams/mole, or 48,000 to 53,000 grams/mole. Within the range of 15,000 to 24,000 grams/mole, the second number average molecular weight, $M_n2$, can be 16,000 to 23,000 grams/mole, or 17,000 to 22,000 grams/mole. Within the range of 2.45 to 3.00, the second dispersity, $M_w2/M_n2$, can be 2.5 to 2.9, or 2.5 to 2.7. Within the range of 31,000 to 65,000 grams/mole, the blend weight average molecular weight, $M_w$blend, can be 31,000 to 60,000 grams/mole, or 35,000 to 60,000 grams/mole, or 40,000 to 55,000 grams/mole, or 40,000 to 52,000 grams/mole. Within the range of 13,000 to 25,000 grams/mole, the blend number average molecular weight, $M_n$blend, can be 15,000 to 24,000 grams/mole, or 16,000 to 23,000 grams/mole. Within the range of 2.1 to 2.55, the blend dispersity, $M_w$blend/$M_n$blend, can be 2.25 to 2.55, or 2.35 to 2.55, or 2.37 to 2.53.

The pre-blended composition can, optionally, further comprise a carboxylic acid or carboxylic acid anhydride selected from the group consisting of citric acid, fumaric acid, maleic acid, maleic anhydride, formic acid, and combinations thereof. In some embodiments, carboxylic acid and/or carboxylic acid anhydride comprises citric acid. When present, carboxylic acid and/or carboxylic acid anhydride can be used in an amount of 0.3 to 1.6 weight percent, based on the total weight of the pre-blended composition. Within this range, the amount can be 0.4 to 1.2 weight percent. When the carboxylic acid and/or carboxylic acid anhydride is present, the sum of the weight percents of the first poly(phenylene ether), the second poly(phenylene ether), the atactic polystyrene, the hydrogenated block copolymer, and the carboxylic

acid or carboxylic acid anhydride is 95.3 to 100 weight percent. Within this range, the sum of the weight percents of the first poly(phenylene ether), the second poly(phenylene ether), the atactic polystyrene, the hydrogenated block copolymer, and the carboxylic acid or carboxylic acid anhydride can be 96 to 100 weight percent, or 97 to 100 weight percent, or 98 to 100 weight percent, or 99 to 100 weight percent.

In some embodiment of the melt-blended composition, the first poly(phenylene ether) and the second poly(phenylene ether) each comprise a poly(2,6-dimethyl-1,4-phenylene ether). In other embodiments of the melt-blended composition, one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer.

In some embodiments of the melt-blended composition, the atactic polystyrene has a melt flow index of 2 to 25 grams/10 minutes determined according to ASTM D1238-20 at 200 °C and 5 kilograms load.

In a very specific embodiment of the melt-blended composition, the pre-blended composition comprises 65 to 75 weight percent of the first poly(phenylene ether), 10 to 20 weight percent of the second poly(phenylene ether), 10 to 20 weight percent of the atactic polystyrene, and 0 to 10 weight percent of the hydrogenated block copolymer of an alkenyl aromatic compound and a conjugated diene; wherein the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer; and wherein the sum of the weight percents of the first poly(phenylene ether), the second poly(phenylene ether), the atactic polystyrene, and the hydrogenated block copolymer is 97 to 100 weight percent. Within the range of 97 to 100 weight percent, the sum of the weight percents of the first poly(phenylene ether), the second poly(phenylene ether), the atactic polystyrene, and the hydrogenated block copolymer can be 98 to 100 weight percent, or 99 to 100 weight percent.

In one variation of the very specific embodiment of the melt-blended composition, the pre-blended composition further comprises 0.3 to 1.6 weight percent of citric acid, based on the total weight of the pre-blended composition, and the sum of the weight percents of the first poly(phenylene ether), the second poly(phenylene ether), the atactic polystyrene, the hydrogenated block copolymer, and the citric acid is 97.3 to 100 weight percent. Within the range of 0.3 to 1.6 weight percent, the citric acid amount can be 0.4 to 1.2 weight percent. Within the range of 97.3 to 100 weight percent, the sum of the weight percents of the first poly(phenylene ether), the second poly(phenylene ether), the atactic polystyrene, the hydrogenated block copolymer, and the citric acid can be 98 to 100 weight percent, or 99 to 100 weight percent.

In another variation of the very specific embodiment of the melt-blended composition, the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Within the range of 30,000 to 47,000 grams/mole, the first weight average molecular weight, $M_w1$, can be 35,000 to 47,000 grams/mole, or 40,000 to 47,000 grams/mole, or 42,000 to 47,000 grams/mole. Within the range of 15,000 to 24,000 grams/mole, the first number average molecular weight, $M_{n1}$, can be 16,000 to 23,000 grams/mole, or 17,000 to 22,000 grams/mole. Within the range of 2.0 to 2.45, the first dispersity, $M_w1/M_n1$, can be 2.1 to 2.45, or 2.2 to 2.45. Within the range of 47,000 to 65,000 grams/mole, the second weight average molecular weight, $M_w2$, can be 47,000 to 60,000 grams/mole, or 48,000 to 55,000 grams/mole, or 48,000 to 53,000 grams/mole. Within the range of 15,000 to 24,000 grams/mole, the second number average molecular weight, $M_n2$, can be 16,000 to 23,000 grams/mole, or 17,000 to 22,000 grams/mole. Within the range of 2.45 to 3.00, the second dispersity, $M_w2/M_n2$, can be 2.5 to 2.9, or 2.5 to 2.7. Within the range of 3 1,000 to 65,000 grams/mole, the blend weight average molecular weight, $M_w$blend, can be 31,000 to 60,000 grams/mole, or 35,000 to 60,000 grams/mole, or 40,000 to 55,000 grams/mole, or 40,000 to 52,000 grams/mole. Within the range of 13,000 to 25,000 grams/mole, the blend number average molecular weight, $M_n$blend, can be 15,000 to 24,000 grams/mole, or 16,000 to 23,000 grams/mole. Within the range of 2.1 to 2.55, the blend dispersity, $M_w$blend/$M_n$blend, can be 2.25 to 2.55, or 2.35 to 2.55, or 2.37 to 2.53.

Another embodiment is an injection molded article comprising the melt-blended composition in any of its above-described variations.

In some embodiments of the injection molded article, the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Within the range of 30,000 to 47,000 grams/mole, the first weight average molecular weight, $M_w1$, can be

35,000 to 47,000 grams/mole, or 40,000 to 47,000 grams/mole, or 42,000 to 47,000 grams/mole. Within the range of 15,000 to 24,000 grams/mole, the first number average molecular weight, $M_{n1}$, can be 16,000 to 23,000 grams/mole, or 17,000 to 22,000 grams/mole. Within the range of 2.0 to 2.45, the first dispersity, $M_w1/M_n1$, can be 2.1 to 2.45, or 2.2 to 2.45. Within the range of 47,000 to 65,000 grams/mole, the second weight average molecular weight, $M_w2$, can be 47,000 to 60,000 grams/mole, or 48,000 to 55,000 grams/mole, or 48,000 to 53,000 grams/mole. Within the range of 15,000 to 24,000 grams/mole, the second number average molecular weight, $M_n2$, can be 16,000 to 23,000 grams/mole, or 17,000 to 22,000 grams/mole. Within the range of 2.45 to 3.00, the second dispersity, $M_w2/M_n2$, can be 2.5 to 2.9, or 2.5 to 2.7. Within the range of 3 1,000 to 65,000 grams/mole, the blend weight average molecular weight, $M_w$blend, can be 31,000 to 60,000 grams/mole, or 35,000 to 60,000 grams/mole, or 40,000 to 55,000 grams/mole, or 40,000 to 52,000 grams/mole. Within the range of 13,000 to 25,000 grams/mole, the blend number average molecular weight, $M_n$blend, can be 15,000 to 24,000 grams/mole, or 16,000 to 23,000 grams/mole. Within the range of 2.1 to 2.55, the blend dispersity, $M_w$blend/$M_n$blend, can be 2.25 to 2.55, or 2.35 to 2.55, or 2.37 to 2.53.

In some embodiments of the injection molded article, the pre-blended composition further comprises a carboxylic acid or carboxylic acid anhydride selected from the group consisting of citric acid, fumaric acid, maleic acid, maleic anhydride, formic acid, and combinations thereof. In some embodiments, carboxylic acid and/or carboxylic acid anhydride comprises citric acid. When present, carboxylic acid and/or carboxylic acid anhydride can be used in an amount of 0.3 to 1.6 weight percent, based on the total weight of the pre-blended composition. Within this range, the amount can be 0.4 to 1.2 weight percent. When the carboxylic acid and/or carboxylic acid anhydride is present, the sum of the weight percents of the first poly(phenylene ether), the second poly(phenylene ether), the atactic polystyrene, the hydrogenated block copolymer, and the citric acid is 95.3 to 100 weight percent. Within this range, the sum of the weight percents of the first poly(phenylene ether), the second poly(phenylene ether), the atactic polystyrene, the hydrogenated block copolymer, and the carboxylic acid or carboxylic acid anhydride can be 96 to 100 weight percent, or 97 to 100 weight percent, or 98 to 100 weight percent, or 99 to 100 weight percent.

In a very specific embodiment of the injection molded article, the pre-blended composition comprises 65 to 75 weight percent of the first poly(phenylene ether), 10 to 20 weight percent of the second poly(phenylene ether), 10 to 20 weight percent of the atactic polystyrene, and 0 to 10 weight percent of the hydrogenated block copolymer of an alkenyl aromatic compound and a conjugated diene; wherein the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer; and wherein the sum of the weight percents of the first poly(phenylene ether), the second poly(phenylene ether), the atactic polystyrene, and the hydrogenated block copolymer is 97 to 100 weight percent. Within the range of 97 to 100 weight percent, the sum of the weight percents of the first poly(phenylene ether), the second poly(phenylene ether), the atactic polystyrene, and the hydrogenated block copolymer can be 98 to 100 weight percent, or 99 to 100 weight percent.

In one variation of the very specific embodiment of the injection molded article, the pre-blended composition further comprises 0.3 to 1.6 weight percent of citric acid, based on the total weight of the pre-blended composition, and the sum of the weight percents of the first poly(phenylene ether), the second poly(phenylene ether), the atactic polystyrene, the hydrogenated block copolymer, and the citric acid is 97.3 to 100 weight percent. Within the range of 0.3 to 1.6 weight percent, the citric acid amount can be 0.4 to 1.2 weight percent. Within the range of 97.3 to 100 weight percent, the sum of the weight percents of the first poly(phenylene ether), the second poly(phenylene ether), the atactic polystyrene, the hydrogenated block copolymer, and the citric acid can be 98 to 100 weight percent, or 99 to 100 weight percent.

In another variation of the very specific embodiment of the injection molded article, the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Within the range of 30,000 to 47,000 grams/mole, the first weight average molecular weight, $M_w1$, can be 35,000 to 47,000 grams/mole, or 40,000 to 47,000 grams/mole, or 42,000 to 47,000 grams/mole. Within the range of 15,000 to 24,000 grams/mole, the first number average molecular weight, $M_{n1}$, can be 16,000 to 23,000 grams/mole, or 17,000 to 22,000 grams/mole. Within the range of 2.0 to 2.45, the first dispersity, $M_w1/M_n1$, can be 2.1 to 2.45, or 2.2 to 2.45. Within the range of 47,000 to 65,000 grams/mole, the second weight average molecular weight, $M_w2$, can be 47,000 to 60,000 grams/mole, or 48,000 to 55,000 grams/mole, or 48,000 to 53,000 grams/mole. Within the range of 15,000 to 24,000 grams/mole, the second number average molecular weight, $M_n2$, can be 16,000 to 23,000 grams/mole, or 17,000 to 22,000 grams/mole. Within the range of 2.45 to 3.00, the second dispersity, $M_w2/M_n2$, can be 2.5 to 2.9, or 2.5 to 2.7. Within the range of 31,000 to 65,000 grams/mole, the blend weight average molecular weight, $M_w$blend, can be 31,000 to 60,000 grams/mole, or 35,000 to 60,000 grams/mole, or 40,000 to 55,000 grams/mole, or 40,000 to

52,000 grams/mole. Within the range of 13,000 to 25,000 grams/mole, the blend number average molecular weight, $M_n$blend, can be 15,000 to 24,000 grams/mole, or 16,000 to 23,000 grams/mole. Within the range of 2.1 to 2.55, the blend dispersity, $M_w$blend/$M_n$blend, can be 2.25 to 2.55, or 2.35 to 2.55, or 2.37 to 2.53.

All ranges disclosed herein are inclusive of the endpoints, and the endpoints are independently combinable with each other. Each range disclosed herein constitutes a disclosure of any point or sub-range lying within the disclosed range.

The invention is further illustrated by the following non-limiting examples.

EXAMPLES

Materials used to form pre-blended compositions are summarized in Table 1.

Table 1

| Material | Description |
|---|---|
| PPE 1 | Poly(2,6-dimethyl-1,4-phenylene ether), CAS Reg. No. 25134-01-4, having an intrinsic viscosity of 0.40 deciliter/gram measured by Ubbelohde viscometer at 25°C in chloroform. |
| PPE 2 | Poly(2,6-dimethyl-1,4-phenylene ether), CAS Reg. No. 25134-01-4, having an intrinsic viscosity of 0.46 deciliter/gram measured by Ubbelohde viscometer at 25°C in chloroform. |
| PS | Atactic polystyrene, CAS Reg. No. 9003-53-6, having a melt flow index of 9 grams/10 minutes, measured at 200 °C and 5 kilogram load. |
| SEBS | Polystyrene-poly(ethylene-butylene)-polystyrene triblock copolymer having a polystyrene content of 30 weight percent. |
| PC 1 | Bisphenol A polycarbonate, having a melt flow index of about 6 grams/10 minutes measured at 300 °C and 1.2 kilogram load. |
| PC 2 | Bisphenol A polycarbonate, having a melt flow index of about 25 grams/10 minutes measured at 300 °C and 2.16 kilogram load. |
| PC 3 | Copolycarbonate of 67 mole percent bisphenol A and 33 mole percent bisphenol isophorone, having a melt flow index of about 15 grams/10 minutes measured at 330 °C and 2.16 kilogram load. |
| CA | Citric acid, CAS Reg. No. 77-92-9. |
| Additives | One or more additives selected from antioxidants, mold release agents, and colorants. |

Compositions are summarized in Table 2, where component amounts are expressed in units of weight percent based on the total weight of the composition. Compositions were compound in a twin-screw extruder operating at zone temperatures of 50, 150, 240, 28, 280, 280, 300, 300, 300, 280, and 280 °C, and a die temperature of 290 °C. All components were added at the feed throat, and the extrudate was pelletized and dried for 4 hours at 110 °C before use for injection molding. Test articles were injection molded on a Toshiba UH1000-110 injection molding machine operating at barrel temperatures of 290 °C, 310 °C, 320 °C, and 300 °C (from feed throat to nozzle), and a mold temperature of 90 °C.

Reflective articles were prepared by vapor deposition of an aluminum layer having a thickness of about 100 nanometers micrometers on a surface of an injection molded article having a thickness of about 2 to 3 millimeters. The substrate surface was plasma treated before aluminum deposition.

Compositions and properties are summarized in Table 2. Values of tensile stress at yield, having units of megapascals, were determined at 23 °C according to ASTM D638-14 at a sample thickness of 3.2 millimeters and a test speed of 5 millimeters per minute. Values of flexural strength and flexural modulus, both having units of megapascals, were determined at 23 °C according to ASTM D790-17 at a sample thickness of 6.4 millimeters and a test speed of 2.5 millimeters per minute. Values of heat deflection temperature, having units of degrees centigrade, were determined according to ASTM D648-18 at the specified sample thickness and load. Values of melt flow rate, having units of grams/10 minutes, were determined according to ASTM D1238-20 at the specified temperature and load. Values of specific gravity, which are unitless, were determined according to ASTM D792-20 at 23 °C. Water absorption values, having units of weight percent, was determined according to ISO 62:2008 at 23 °C and 24 hours exposure.

Mold shrinkage values, having units of percent, were determined as follows. Test samples were injection molded in a molding tool having dimensions 60 millimeters by 60 millimeters by 2 millimeters. The tool length, $L_{tool}$, was therefore 60 millimeters. After molding, the samples were held at 23 °C and 50 percent relative humidity for 48 hours. The length of the specimen was then measured in one of the dimensions corresponding to 60 millimeters in the molding tool to yield

a sample length value, $L_{sample}$. Mold shrinkage was calculated according to the formula

$$\text{Mold Shrinkage} = 100\times(L_{tool}-L_{sample})/L_{tool}$$

Mold shrinkage results for three samples per composition were averaged to yield the values presented in Table 2.

Surface appearance was determined by visual inspection of as-molded samples (i.e., before metallization). A rating of "defects" indicating that defects were observed on the surface of the article, and a rating of "no defects" indicating that no defects were observed on the surface of the article.

Outgassing was determined on 10gram pellets. The pellets were conditioned for 48 hours at 23 °C and 50 percent relative humidity. The pellets were then placed in a cylindrical vessel with a diameter of 300 millimeters and a height of 300 millimeters. The vessel included a clear glass top. The vessel and its pellet contents were exposed to a temperature of 150 °C and an absolute pressure of 101.3 kilopascals for 8 hours. After the vessel cooled, the clear glass top was removed and its percent haze value was determined according to MS300-54:2014, the Hyundai-Kia standard test method for "Fogging Test." An outgassing rating of "high" means that the percent haze value of the clear glass after the test was greater than or equal to 5 percent, and a rating of "low" means that the percent haze value of the glass after the test was less than 5 percent.

Metal layer adhesion was determined on reflective (i.e., metallized) articles by cross-cut testing under three conditions: after initial preparation of the sample, after aging at 150 °C for 10 hours, and after aging at 50 °C and 95 percent relative humidity for 240 hours. A rating of "good" means that inspection of the cross-cut surface revealed little or no separation of the metal layer from the substrate, and a rating of "not good" means that inspection of the cross-cut surface revealed significant separation of the metal layer from the substrate. It should be noted that a rating of "good" after aging at 150°C for 10 hours is sufficient for most uses of the reflective article. A rating of "good" after aging at 50 °C and 95 percent relative humidity for 240 hours is required only for a minority of uses encountering the most challenging conditions.

The property results in Table 2 show that, relative to polycarbonate-based Comparative Examples 1 and 2, poly(phenylene ether)-based inventive Examples 1-3 exhibit lower specific gravity. At current market prices, the materials used to form the poly(phenylene ether)-based reflective articles of Examples 1-3 are also substantially less expensive than the materials used to form the polycarbonate-based reflective articles of Comparative Examples 1 and 2. Furthermore, relative to polycarbonate-based Comparative Examples 1 and 2, poly(phenylene ether)-based inventive Examples 1-3 exhibit greater tensile stress at yield, greater flexural strength, comparable or greater flexural modulus, comparable heat deflection temperatures, lower water absorptions, and comparable mold shrinkage values. In short, the inventive examples were superior to the polycarbonate-based comparative examples in specific gravity, cost, tensile stress at yield, flexural strength, and water absorption, while being at least comparable in flexural modulus, heat deflection temperature, and mold shrinkage. It should also be noted that Example 1-3 each exhibited no surface defects, low outgassing, and good metal adhesion for samples as-prepared and after 10 hours at 150 °C. Example 2 further exhibited good metal adhesion after 240 hours at 50 °C and 95% relative humidity.

Table 2

| | C. Ex. 1 | C Ex. 2 | C. Ex. 3 |
|---|---|---|---|
| COMPOSITION | | | |
| PPE 1 | 0 | 0 | 0 |
| PPE 2 | 0 | 0 | 69.65 |
| PS | 0 | 0 | 29.85 |
| SEBS | 0 | 0 | 0 |
| CA | 0 | 0 | 0 |
| PC 1 | 15.91 | 8.81 | 0 |
| PC 2 | 20.00 | 8.80 | 0 |
| PC 3 | 63.70 | 82.00 | 0 |
| Additives | 0.39 | 0.39 | 0.50 |
| PROPERTIES | | | |
| Tensile stress at yield (MPa) | 55 | 69 | 80 |

(continued)

| | | | |
|---|---|---|---|
| PROPERTIES | | | |
| Flexural strength (MPa) | 80 | 80 | 119 |
| Flexural modulus (MPa) | 2500 | 2600 | 2800 |
| HDT at 6.4 mm/0.45 MPa (°C) | -- | -- | 147 |
| HDT at 6.4 mm/1.82 MPa (°C) | -- | -- | -- |
| HDT at 3.2 mm/0.45 MPa (°C) | 166 | 174 | -- |
| HDT at 3.2 mm/1.82 MPa (°C) | 156 | 165 | -- |
| MFR at 300°C/5 kg (g/10 min) | -- | -- | 14.2 |
| MFR at 330°C/1.2 kg (g/10 min) | -- | -- | -- |
| MFR at 330°C/2.16 kg (g/ 10 min) | 33 | 25 | -- |
| Specific gravity | 1.20 | 1.20 | 1.08 |
| Water absorption (%) | 0.30 | 0.25 | 0.10 |
| Mold shrinkage (%) | 0.6-0.9 | 0.6-0.95 | 0.5-0.7 |
| Surface appearance | -- | -- | defects |
| Outgassing | -- | -- | high |
| Metal layer adhesion, initial | -- | -- | -- |
| Metal layer adhesion, after 10 h at 150°C | -- | -- | -- |
| Metal layer adhesion, after 240 h at 50°C, 95% RH | -- | -- | -- |

| Table 2 (cont.) | | | |
|---|---|---|---|
| | \| Ex. 1 | \| Ex. 2 | \| Ex. 3 |
| COMPOSITION | | | |
| PPE 1 | 71.64 | 71.10 | 71.64 |
| PPE 2 | 13.93 | 13.88 | 10.43 |
| PS | 13.93 | 13.83 | 13.93 |
| SEBS | 0 | 0 | 3.50 |
| CA | 0 | 0.70 | 0 |
| PC 1 | 0 | 0 | 0 |
| PC 2 | 0 | 0 | 0 |
| PC 3 | 0 | 0 | 0 |
| Additives | 0.50 | 0.50 | 0.50 |
| PROPERTIES | | | |
| Tensile stress at yield (MPa) | 77.6 | 77.4 | 73.4 |
| Flexural strength (MPa) | 118 | 118 | 113 |
| Flexural modulus (MPa) | 2780 | 2820 | 2700 |
| HDT at 6.4 mm/0.45 MPa (°C) | 175 | 176 | 174 |
| HDT at 6.4 mm/1.82 MPa (°C) | 163 | 164 | 162 |
| HDT at 3.2 mm/0.45 MPa (°C) | 175 | 175 | 173 |
| HDT at 3.2 mm/1.82 MPa (°C) | 160 | 161 | 158 |
| MFR at 300°C/5 kg (g/10 min) | 8.47 | 8.50 | 9.0 |

(continued)

| PROPERTIES | | | |
|---|---|---|---|
| MFR at 330°C/1.2 kg (g/10 min) | 7.48 | 6.63 | 7.4 |
| MFR at 330°C/2.16 kg (g/10 min) | -- | -- | -- |
| Specific gravity | 1.07 | 1.07 | 1.07 |
| Water absorption (%) | 0.10 | 0.14 | 0.14 |
| Mold shrinkage (%) | 0.77 | 0.78 | -- |
| Surface appearance | no defects | no defects | no defects |
| Outgassing | low | low | low |
| Metal layer adhesion, initial | good | good | good |
| Metal layer adhesion, after 10 h at 150°C | good | good | good |
| Metal layer adhesion, after 240 h at 50°C, 95% RH | not good | good | not good |

Table 3 summarizes the molecular weight characteristics of PPE 1 (C. Ex. 4), PPE 2 (C. Ex. 5), and the blends of PPE 1 and PPE 2 used in Examples 1-3. PPE amounts in Table 3 are expressed in parts by weight.

Table 3

| | Ex. 1 | Ex. 2 | Ex. 3 | C. Ex. 4 | C. Ex. 5 |
|---|---|---|---|---|---|
| COMPOSITION | | | | | |
| PPE 1 | 71.64 | 71.1 | 71.64 | 100 | 0 |
| PPE 2 | 13.93 | 13.88 | 10.43 | 0 | 100 |
| PROPERTIES | | | | | |
| $M_w$ (g/mol) | 46287 | 46558 | 46244 | 45150 | 49449 |
| $M_n$ (g/mol) | 19126 | 19163 | 19233 | 19309 | 19242 |
| Dispersity ($M_w/M_n$) | 2.42 | 2.43 | 2.40 | 2.34 | 2.57 |

The invention includes at least the following aspects.

Aspect 1: A reflective article comprising: an injection molded thermoplastic substrate; and a reflective metal layer disposed on a surface of the thermoplastic substrate; wherein the injection molded thermoplastic substrate comprises a melt-blended composition comprising the product of melt-blending a pre-blended composition comprising, based on the total weight of the pre-blended composition, 40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_{n1}$, and a first dispersity, $M_w1/M_n1$, determined according to ASTM D5296-19 using gel permeation chromatography with polystyrene standards; 5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards; 5 to 25 weight percent of an atactic polystyrene; and 0 to 10 weight percent of a hydrogenated block copolymer of an alkenyl aromatic compound and a conjugated diene; wherein a blend of the 40 to 90 weight percent of the first poly(phenylene ether) and the 5 to 25 weight percent of the second poly(phenylene ether) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

Aspect 2: The reflective article of aspect 1, wherein the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45; the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

Aspect 3: The reflective article of aspect 1 or 2, wherein the pre-blended composition further comprises 0.3 to 1.6 weight percent of a carboxylic acid or carboxylic acid anhydride selected from the group consisting of citric acid, fumaric acid, maleic acid, maleic anhydride, formic acid, and combinations thereof; wherein the sum of the weight percents of the first poly(phenylene ether), the second poly(phenylene ether), the atactic polystyrene, the hydrogenated block copolymer, and the carboxylic acid or carboxylic acid anhydride is 95.3 to 100 weight percent.

Aspect 4: The reflective article of any one of aspects 1-3, wherein one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer.

Aspect 5: The reflective article of aspect 1, wherein the pre-blended composition comprises 65 to 75 weight percent of the first poly(phenylene ether), 10 to 20 weight percent of the second poly(phenylene ether), 10 to 20 weight percent of the atactic polystyrene, and 0 to 10 weight percent of the hydrogenated block copolymer of an alkenyl aromatic compound and a conjugated diene; the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether) and the other of the first and second poly(phenylene ether)s comprises a poly(phenylene ether)-polysiloxane block copolymer; and the sum of the weight percents of the first poly(phenylene ether), the second poly(phenylene ether), the atactic polystyrene, and the hydrogenated block copolymer is 97 to 100 weight percent.

Aspect 6: The reflective article of aspect 5, wherein the pre-blended composition further comprises 0.3 to 1.6 weight percent of citric acid, based on the total weight of the pre-blended composition; and wherein the sum of the weight percents of the first poly(phenylene ether), the second poly(phenylene ether), the atactic polystyrene, the hydrogenated block copolymer, and the citric acid is 97.3 to 100 weight percent.

Aspect 7: The reflective article of any one of aspects 1-6 selected from the group consisting of automotive headlight reflectors, automotive bezels, automotive head up display reflectors, automotive interior parts, home appliance lighting reflectors, home appliance bezels, consumer electronics lighting reflectors, and consumer electronics bezels.

Aspect 8: The reflective article of aspect 7, wherein the reflective article is an automotive headlight reflector.

Aspect 9: A melt-blended composition comprising the product of melt-blending a pre-blended composition comprising, based on the total weight of the pre-blended composition: 40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_{n1}$, and a first dispersity, $M_W1/M_n1$, determined according to ASTM D5296-19 using gel permeation chromatography with polystyrene standards; 5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards; 5 to 25 weight percent of an atactic polystyrene; and 0 to 10 weight percent of a hydrogenated block copolymer of an alkenyl aromatic compound and a conjugated diene; wherein a blend of the 40 to 90 weight percent of the first poly(phenylene ether) and the 5 to 25 weight percent of the second poly(phenylene ether) exhibits a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

Aspect 10: The melt-blended composition of aspect 9, wherein the pre-blended composition further comprises 0.3 to 1.6 weight percent of a carboxylic acid or carboxylic acid anhydride selected from the group consisting of citric acid, fumaric acid, maleic acid, maleic anhydride, formic acid, and combinations thereof; wherein the sum of the weight percents of the first poly(phenylene ether), the second poly(phenylene ether), the atactic polystyrene, the hydrogenated block copolymer, and the carboxylic acid or carboxylic acid anhydride is 95.3 to 100 weight percent.

Aspect 11: The melt-blended composition of aspect 9 or 10, wherein one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer.

Aspect 12: The melt-blended composition of aspect 9, wherein the pre-blended composition comprises 65 to 75 weight percent of the first poly(phenylene ether), 10 to 20 weight percent of the second poly(phenylene ether), 10 to 20 weight percent of the atactic polystyrene, and 0 to 10 weight percent of the hydrogenated block copolymer of an alkenyl aromatic compound and a conjugated diene; wherein the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether) and the other of the first and second poly(phenylene ether)s comprises a poly(phenylene ether)-polysiloxane block copolymer; and wherein the sum of the weight percents of the first poly(phenylene ether), the second poly(phenylene ether), the atactic polystyrene, and the hydrogenated block copolymer is 97 to 100 weight percent.

Aspect 13: The melt-blended composition of aspect 12, wherein the pre-blended composition further comprises 0.3 to 1.6 weight percent of citric acid, based on the total weight of the pre-blended composition; and wherein the sum of the weight percents of the first poly(phenylene ether), the second poly(phenylene ether), the atactic polystyrene, the hydrogenated block copolymer, and the citric acid is 97.3 to 100 weight percent.

Aspect 14: An injection molded article comprising the melt-blended composition of any one of aspects 9-13.

Aspect 15: The injection molded article of aspect 14, comprising the melt-blended composition of aspect 12 or 13.

## Claims

**1.** A reflective article comprising:

an injection molded thermoplastic substrate; and
a reflective metal layer disposed on a surface of the thermoplastic substrate;
wherein the injection molded thermoplastic substrate comprises a melt-blended composition comprising the product of melt-blending a pre-blended composition comprising, based on the total weight of the pre-blended composition,

40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_n1$, and a first dispersity, $M_w1/M_n1$, determined according to ASTM D5296-19 using gel permeation chromatography with polystyrene standards;
5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards;
5 to 25 weight percent of an atactic polystyrene; and
0 to 10 weight percent of a hydrogenated block copolymer of an alkenyl aromatic compound and a conjugated diene;
wherein a blend of the 40 to 90 weight percent of the first poly(phenylene ether) and the 5 to 25 weight percent of the second poly(phenylene ether) has a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and
wherein the sum of the weight percents of the first poly(phenylene ether), the second poly(phenylene ether), the atactic polystyrene, and the hydrogenated block copolymer is 95 to 100 weight percent.

**2.** The reflective article of claim 1, wherein

the first weight average molecular weight, $M_w1$, is 30,000 to 47,000 grams/mole, the first number average molecular weight, $M_n1$ is 15,000 to 24,000 grams/mole, and the first dispersity, $M_w1/M_n1$ is 2.0 to 2.45;
the second weight average molecular weight, $M_w2$, is greater than 47,000 to 65,000 grams/mole, the second number average molecular weight, $M_n2$, is 15,000 to 24,000 grams/mole, and the second dispersity, $M_w2/M_n2$, is greater than 2.45 to 3.00; and

the blend weight average molecular weight, $M_w$blend, is 31,000 to 65,000 grams/mole, the blend number average molecular weight, $M_n$blend, is 13,000 to 25,000 grams/mole, and the blend dispersity, $M_w$blend/$M_n$blend is 2.1 to 2.55.

**3.** The reflective article of claim 1 or 2, wherein the pre-blended composition further comprises 0.3 to 1.6 weight percent of a carboxylic acid or carboxylic acid anhydride selected from the group consisting of citric acid, fumaric acid, maleic acid, maleic anhydride, formic acid, and combinations thereof; wherein the sum of the weight percents of the first poly(phenylene ether), the second poly(phenylene ether), the atactic polystyrene, the hydrogenated block copolymer, and the carboxylic acid or carboxylic acid anhydride is 95.3 to 100 weight percent.

**4.** The reflective article of any one of claims 1-3, wherein one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer.

**5.** The reflective article of claim 1, wherein

the pre-blended composition comprises

65 to 75 weight percent of the first poly(phenylene ether),
10 to 20 weight percent of the second poly(phenylene ether),
10 to 20 weight percent of the atactic polystyrene, and
0 to 10 weight percent of the hydrogenated block copolymer of an alkenyl aromatic compound and a conjugated diene;

the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether) and the other of the first and second poly(phenylene ether)s comprises a poly(phenylene ether)-polysiloxane block copolymer; and
the sum of the weight percents of the first poly(phenylene ether), the second poly(phenylene ether), the atactic polystyrene, and the hydrogenated block copolymer is 97 to 100 weight percent.

**6.** The reflective article of claim 5, wherein the pre-blended composition further comprises 0.3 to 1.6 weight percent of citric acid, based on the total weight of the pre-blended composition; and wherein the sum of the weight percents of the first poly(phenylene ether), the second poly(phenylene ether), the atactic polystyrene, the hydrogenated block copolymer, and the citric acid is 97.3 to 100 weight percent.

**7.** The reflective article of any one of claims 1-6 selected from the group consisting of automotive headlight reflectors, automotive bezels, automotive head up display reflectors, automotive interior parts, home appliance lighting reflectors, home appliance bezels, consumer electronics lighting reflectors, and consumer electronics bezels.

**8.** The reflective article of claim 7, wherein the reflective article is an automotive headlight reflector.

**9.** A melt-blended composition comprising the product of melt-blending a pre-blended composition comprising, based on the total weight of the pre-blended composition:

40 to 90 weight percent of a first poly(phenylene ether) having an intrinsic viscosity of 0.3 to 0.43 deciliter/gram, determined in chloroform at 23°C by Ubbelohde viscometer, and having a first weight average molecular weight, $M_w1$, a first number average molecular weight, $M_n1$, and a first dispersity, $M_w1/M_n1$, determined according to ASTM D5296-19 using gel permeation chromatography with polystyrene standards;
5 to 25 weight percent of a second poly(phenylene ether) having an intrinsic viscosity of greater than 0.43 to 0.49 deciliter/gram, determined in chloroform at 23°C by Ubbelohde viscometer; provided that the intrinsic viscosity of the second poly(phenylene ether) is 0.03 to 0.09 deciliter/gram greater than the intrinsic viscosity of the first poly(phenylene ether); wherein the second poly(phenylene ether) has a second weight average molecular weight, $M_w2$, a second number average molecular weight, $M_n2$, and a second dispersity, $M_w2/M_n2$, determined according to ASTM D5296-19 using gel permeation chromatography with polystyrene standards;
5 to 25 weight percent of an atactic polystyrene; and
0 to 10 weight percent of a hydrogenated block copolymer of an alkenyl aromatic compound and a conjugated diene;

wherein a blend of the 40 to 90 weight percent of the first poly(phenylene ether) and the 5 to 25 weight percent of the second poly(phenylene ether) exhibits a blend weight average molecular weight, $M_w$blend, a blend number average molecular weight, $M_n$blend, and a blend dispersity, $M_w$blend/$M_n$blend, determined according to ASTM D5296-19 using gel permeation chromatography with polystyrene standards; wherein the blend dispersity, $M_w$blend, is greater than the first dispersity, $M_w1/M_n1$, and less than the second dispersity, $M_w2/M_n2$; and wherein the sum of the weight percents of the first poly(phenylene ether), the second poly(phenylene ether), the atactic polystyrene, and the hydrogenated block copolymer is 95 to 100 weight percent.

**10.** The melt-blended composition of claim 9, wherein the pre-blended composition further comprises 0.3 to 1.6 weight percent of a carboxylic acid or carboxylic acid anhydride selected from the group consisting of citric acid, fumaric acid, maleic acid, maleic anhydride, formic acid, and combinations thereof; wherein the sum of the weight percents of the first poly(phenylene ether), the second poly(phenylene ether), the atactic polystyrene, the hydrogenated block copolymer, and the carboxylic acid or carboxylic acid anhydride is 95.3 to 100 weight percent.

**11.** The melt-blended composition of claim 9 or 10, wherein one of the first and second poly(phenylene ether)s comprises a poly(2,6-dimethyl-1,4-phenylene ether), and the other of the first and second poly(phenylene ether)s comprises a poly(phenylene ether)-polysiloxane block copolymer.

**12.** The melt-blended composition of claim 9,

wherein the pre-blended composition comprises

65 to 75 weight percent of the first poly(phenylene ether),
10 to 20 weight percent of the second poly(phenylene ether),
10 to 20 weight percent of the atactic polystyrene, and
0 to 10 weight percent of the hydrogenated block copolymer of an alkenyl aromatic compound and a conjugated diene;

wherein the first poly(phenylene ether) and the second poly(phenylene ether) each comprise a poly(2,6-dimethyl-1,4-phenylene ether), or one of the first and second poly(phenylene ether)s comprises a poly(2,6-dimethyl-1,4-phenylene ether) and the other of the first and second poly(phenylene ether)s comprises a poly(phenylene ether)-polysiloxane block copolymer; and
wherein the sum of the weight percents of the first poly(phenylene ether), the second poly(phenylene ether), the atactic polystyrene, and the hydrogenated block copolymer is 97 to 100 weight percent.

**13.** The melt-blended composition of claim 12, wherein the pre-blended composition further comprises 0.3 to 1.6 weight percent of citric acid, based on the total weight of the pre-blended composition; and wherein the sum of the weight percents of the first poly(phenylene ether), the second poly(phenylene ether), the atactic polystyrene, the hydrogenated block copolymer, and the citric acid is 97.3 to 100 weight percent.

**14.** An injection molded article comprising the melt-blended composition of any one of claims 9-13.

**15.** The injection molded article of claim 14, comprising the melt-blended composition of claim 12 or 13.

## Patentansprüche

**1.** Reflektierender Gegenstand, Folgendes umfassend:

ein spritzgegossenes thermoplastisches Substrat; und
eine reflektierende Metallschicht, die auf einer Oberfläche des thermoplastischen Substrats angeordnet ist;
wobei das spritzgegossene thermoplastische Substrat eine schmelzgemischte Zusammensetzung umfasst, die das Produkt des Schmelzmischens einer vorgemischten Zusammensetzung umfasst, die, bezogen auf das Gesamtgewicht der vorgemischten Zusammensetzung, Folgendes umfasst:

40 bis 90 Gew.-% eines ersten Poly(phenylenethers) mit einer intrinsischen Viskosität von 0,3 bis 0,43 Deziliter/Gramm, bestimmt in Chloroform bei 23°C mit einem Ubbelohde-Viskosimeter, und mit einem ersten gewichtsmittleren Molekulargewicht, $M_w1$, einem ersten zahlenmittleren Molekulargewicht, $M_{n1}$, und

einer ersten Dispersität, $M_w1/M_n1$, bestimmt gemäß ASTM D5296-19 unter Verwendung von Gelpermeationschromatographie mit Polystyrol-Standards;

5 bis 25 Gew.-% eines zweiten Poly(phenylenethers) mit einer Grenzviskosität von mehr als 0,43 bis 0,49 Deziliter/Gramm, bestimmt in Chloroform bei 23°C mit einem Ubbelohde-Viskosimeter; mit der Maßgabe, dass die Grenzviskosität des zweiten Poly(phenylenethers) 0,03 bis 0,09 Deziliter/Gramm größer ist als die intrinsische Viskosität des ersten Poly(phenylenethers);

wobei der zweite Poly(phenylenether) ein zweites gewichtsmittleres Molekulargewicht, $M_W2$, ein zweites zahlenmittleres Molekulargewicht, $M_n2$, und eine zweite Dispersität, $M_W2/ M_n2$, bestimmt gemäß ASTM D5296-19 unter Verwendung von Gelpermeationschromatographie mit Polystyrol-Standards, aufweist; 5 bis 25 Gew.-% eines ataktischen Polystyrols; und 0 bis 10 Gew.-% eines hydrierten Blockcopolymers aus einer alkenylaromatischen Verbindung und einem konjugierten Dien;

wobei ein Blend aus den 40 bis 90 Gew.-% des ersten Poly(phenylenethers) und den 5 bis 25 Gew.-% des zweiten Poly(phenylenethers) ein gewichtsmittleres Blend-Molekulargewicht, $M_W$blend, ein zahlenmittleres Blend-Molekulargewicht, $M_n$blend, und eine Blend-Dispersität, $M_W$blend/$M_n$blend, bestimmt gemäß ASTM D5296-19 unter Verwendung von Gelpermeationschromatographie mit Polystyrol-Standards, aufweist;

wobei die Blend-Dispersität, $M_W$blend, größer als die erste Dispersität, $M_w1/M_n1$, und kleiner als die zweite Dispersität, $M_w2/M_n2$, ist; und

wobei die Summe der Gewichtsprozente des ersten Poly(phenylenethers), des zweiten Poly(phenylenethers), des ataktischen Polystyrols und des hydrierten Blockcopolymers 95 bis 100 Gew.-% beträgt.

**2.** Reflektierender Gegenstand nach Anspruch 1, wobei

das erste gewichtsmittlere Molekulargewicht, $M_W1$, 30.000 bis 47.000 Gramm/Mol beträgt, das erste zahlenmittlere Molekulargewicht, $M_{n1}$, 15.000 bis 24.000 Gramm/Mol beträgt und die erste Dispersität, $M_W1/M_n1$, 2,0 bis 2,45 beträgt;

das zweite gewichtsmittlere Molekulargewicht, $M_W2$, größer als 47.000 bis 65.000 Gramm/Mol ist, das zweite zahlenmittlere Molekulargewicht, $M_n2$, 15.000 bis 24.000 Gramm/Mol beträgt, und die zweite Dispersität, $M_W2/M_n2$, größer als 2,45 bis 3,00 ist; und

das gewichtsmittleres Blend-Molekulargewicht, $M_W$blend, 31.000 bis 65.000 Gramm/Mol beträgt, das zahlenmittleres Blend-Molekulargewicht, $M_n$blend, 13.000 bis 25.000 Gramm/Mol beträgt, und die Blend-Dispersität, $M_W$blend/$M_n$blend, 2,1 bis 2,55 beträgt.

**3.** Reflektierender Gegenstand nach Anspruch 1 oder 2, wobei die

vorgemischte Zusammensetzung ferner 0,3 bis 1,6 Gew.-% einer Carbonsäure oder eines Carbonsäureanhydrids, ausgewählt aus der Gruppe bestehend aus Zitronensäure, Fumarsäure, Maleinsäure, Maleinsäureanhydrid, Ameisensäure und Kombinationen davon, umfasst;

wobei die Summe der Gewichtsprozente des ersten Poly(phenylenethers), des zweiten Poly(phenylenethers), des ataktischen Polystyrols, des hydrierten Blockcopolymers und der Carbonsäure oder des Carbonsäureanhydrids 95,3 bis 100 Gew.-% beträgt.

**4.** Reflektierender Gegenstand nach einem der Ansprüche 1 bis 3, wobei einer der ersten und zweiten Poly(phenylenether) ein Poly(2,6-dimethyl-1,4-phenylenether) umfasst und der andere der ersten und zweiten Poly(phenylenether) ein Poly(phenylenether)-Polysiloxan-Blockcopolymer umfasst.

**5.** Reflektierender Gegenstand nach Anspruch 1, wobei

die vorgemischte Zusammensetzung Folgendes aufweist:

65 bis 75 Gew.-% des ersten Poly(phenylenethers),
10 bis 20 Gew.-% des zweiten Poly(phenylenethers),
10 bis 20 Gew.-% des ataktischen Polystyrols und
0 bis 10 Gew.-% des hydrierten Blockcopolymers aus einer aromatischen Alkenylverbindung und einem konjugierten Dien;

wobei der erste Poly(phenylenether) und der zweite Poly(phenylenether) jeweils einen Poly(2,6-dimethyl-1,4-phenylenether) umfassen, oder einer der ersten und zweiten Poly(phenylenether) einen Poly(2,6-dimethyl-1,4-phenylenether) umfasst und der andere der ersten und zweiten Poly(phenylenether) ein Poly(phenylenether)-Polysiloxan-Blockcopolymer umfasst; und
die Summe der Gewichtsprozente des ersten Poly(phenylenethers), des zweiten Poly(phenylenethers), des ataktischen Polystyrols und des hydrierten Blockcopolymers 97 bis 100 Gew.-% beträgt.

**6.** Reflektierender Gegenstand nach Anspruch 5, wobei die vorgemischte Zusammensetzung ferner 0,3 bis 1,6 Gew.-% Zitronensäure, bezogen auf das Gesamtgewicht der vorgemischten Zusammensetzung, umfasst; und wobei die Summe der Gewichtsprozente des ersten Poly(phenylenethers), des zweiten Poly(phenylenethers), des ataktischen Polystyrols, des hydrierten Blockcopolymers und der Zitronensäure 97,3 bis 100 Gew.-% beträgt.

**7.** Reflektierender Gegenstand nach einem der Ansprüche 1 bis 6, ausgewählt aus der Gruppe bestehend aus Fahrzeug-Scheinwerferreflektoren, Fahrzeug-Blenden, Fahrzeug-Head-up-Display-Reflektoren, Fahrzeug-Innenteilen, Haushaltsgeräte-Beleuchtungsreflektoren, Haushaltsgeräte-Blenden, Unterhaltungselektronik-Beleuchtungsreflektoren und Unterhaltungselektronik-Blenden.

**8.** Reflektierender Gegenstand nach Anspruch 7, wobei der reflektierende Gegenstand ein Fahrzeug-Scheinwerferreflektor ist.

**9.** Schmelzgemischte Zusammensetzung, umfassend das Produkt des Schmelzmischens einer vorgemischten Zusammensetzung, die, bezogen auf das Gesamtgewicht der vorgemischten Zusammensetzung, Folgendes umfasst:

40 bis 90 Gew.-% eines ersten Poly(phenylenethers) mit einer intrinsischen Viskosität von 0,3 bis 0,43 Deziliter/Gramm, bestimmt in Chloroform bei 23°C mit einem Ubbelohde-Viskosimeter, und mit einem ersten gewichtsmittleren Molekulargewicht, $M_W1$, einem ersten zahlenmittleren Molekulargewicht, $M_{n1}$, und einer ersten Dispersität, $M_W1/M_n1$, bestimmt gemäß ASTM D5296-19 unter Verwendung von Gelpermeationschromatographie mit Polystyrol-Standards;
5 bis 25 Gew.-% eines zweiten Poly(phenylenethers) mit einer Grenzviskosität von mehr als 0,43 bis 0,49 Deziliter/Gramm, bestimmt in Chloroform bei 23 °C mit einem Ubbelohde-Viskosimeter; mit der Maßgabe, dass die Grenzviskosität des zweiten Poly(phenylenethers) 0,03 bis 0,09 Deziliter/Gramm größer ist als die intrinsische Viskosität des ersten Poly(phenylenethers); wobei der zweite Poly(phenylenether) ein zweites gewichtsmittleres Molekulargewicht, $M_W2$, ein zweites zahlenmittleres Molekulargewicht, $M_n2$, und eine zweite Dispersität, $M_W2/ M_n2$, bestimmt gemäß ASTM D5296-19 unter Verwendung von Gelpermeationschromatographie mit Polystyrol-Standards, aufweist;
5 bis 25 Gew.-% eines ataktischen Polystyrols; und
0 bis 10 Gew.-% eines hydrierten Blockcopolymers aus einer alkenylaromatischen Verbindung und einem konjugierten Dien;
wobei ein Blend aus den 40 bis 90 Gew.-% des ersten Poly(phenylenethers) und den 5 bis 25 Gew.-% des zweiten Poly(phenylenethers) ein gewichtsmittleres Blend-Molekulargewicht, $M_W$blend, ein zahlenmittleres Blend-Molekulargewicht, $M_n$blend, und eine Blend-Dispersität, $M_W$blend/$M_n$blend, bestimmt gemäß ASTM D5296-19 unter Verwendung von Gelpermeationschromatographie mit Polystyrol-Standards, aufweist; wobei die Blend-Dispersität, $M_W$blend, größer als die erste Dispersität, $M_W1/M_n1$, und kleiner als die zweite Dispersität, $M_w2/M_n2$, ist; und
wobei die Summe der Gewichtsprozente des ersten Poly(phenylenethers), des zweiten Poly(phenylenethers), des ataktischen Polystyrols und des hydrierten Blockcopolymers 95 bis 100 Gew.-% beträgt.

**10.** Schmelzgemischte Zusammensetzung nach Anspruch 9, wobei die

vorgemischte Zusammensetzung weiterhin 0,3 bis 1,6 Gew.-% einer Carbonsäure oder eines Carbonsäureanhydrids, ausgewählt aus der Gruppe bestehend aus Zitronensäure, Fumarsäure, Maleinsäure, Maleinsäureanhydrid, Ameisensäure und Kombinationen davon, umfasst;
wobei die Summe der Gewichtsprozente des ersten Poly(phenylenethers), des zweiten Poly(phenylenethers), des ataktischen Polystyrols, des hydrierten Blockcopolymers und der Carbonsäure oder des Carbonsäureanhydrids 95,3 bis 100 Gew.-% beträgt.

**11.** Schmelzgemischte Zusammensetzung nach Anspruch 9 oder 10, wobei einer der ersten und zweiten Poly(phenylenether) ein Poly(2,6-dimethyl-1,4-phenylenether) umfasst und der andere der ersten und zweiten Poly(phenylenether) ein Poly(phenylenether)-Polysiloxan-Blockcopolymer umfasst.

**12.** Schmelzgemischte Zusammensetzung nach Anspruch 9,

wobei die vorgemischte Zusammensetzung Folgendes aufweist:

65 bis 75 Gew.-% des ersten Poly(phenylenethers),
10 bis 20 Gew.-% des zweiten Poly(phenylenethers),
10 bis 20 Gew.-% des ataktischen Polystyrols und
0 bis 10 Gew.-% des hydrierten Blockcopolymers aus einer aromatischen Alkenylverbindung und einem konjugierten Dien umfasst;

wobei der erste Poly(phenylenether) und der zweite Poly(phenylenether) jeweils einen Poly(2,6-dimethyl-1,4-phenylenether) umfassen, oder einer der ersten und zweiten Poly(phenylenether) einen Poly(2,6-dimethyl-1,4-phenylenether) umfasst und der andere der ersten und zweiten Poly(phenylenether) ein Poly(phenylenether)-Polysiloxan-Blockcopolymer umfasst; und
wobei die Summe der Gewichtsprozente des ersten Poly(phenylenethers), des zweiten Poly(phenylenethers), des ataktischen Polystyrols und des hydrierten Blockcopolymers 97 bis 100 Gew.-% beträgt.

**13.** Schmelzgemischte Zusammensetzung nach Anspruch 12, wobei die vorgemischte Zusammensetzung ferner 0,3 bis 1,6 Gew.-% Zitronensäure, bezogen auf das Gesamtgewicht der vorgemischten Zusammensetzung, umfasst; und wobei die Summe der Gewichtsprozente des ersten Poly(phenylenethers), des zweiten Poly(phenylenethers), des ataktischen Polystyrols, des hydrierten Blockcopolymers und der Zitronensäure 97,3 bis 100 Gew.-% beträgt.

**14.** Spritzgegossener Gegenstand, der die schmelzgemischte Zusammensetzung nach einem der Ansprüche 9-13 enthält.

**15.** Spritzgegossener Gegenstand nach Anspruch 14, umfassend die schmelzgemischte Zusammensetzung nach Anspruch 12 oder 13.

## Revendications

**1.** Article réfléchissant, comprenant :

un substrat thermoplastique moulé par injection ; et
une couche de métal réfléchissant disposée sur une surface du substrat thermoplastique ;
dans lequel le substrat thermoplastique moulé par injection comprend une composition mélangée en fusion comprenant le produit du mélange en fusion d'une composition pré-mélangée comprenant, sur la base du poids total de la composition pré-mélangée,
40 à 90 % en poids d'un premier polyphénylène éther ayant une viscosité intrinsèque de 0,3 à 0,43 décilitre/gramme, déterminée dans du chloroforme à 23°C par un viscosimètre Ubbelohde, et ayant un premier poids moléculaire moyen en poids, $M_w1$, un premier poids moléculaire moyen en nombre, $M_n1$, et une première dispersité, $M_w1/M_n1$, déterminée conformément à la norme ASTM D5296-19 en utilisant la chromatographie par perméation de gel avec des standards de polystyrène ;
5 à 25 % en poids d'un deuxième polyphénylène éther ayant une viscosité intrinsèque supérieure à 0,43 à 0,49 décilitre/gramme, déterminée dans du chloroforme à 23°C par un viscosimètre Ubbelohde ; à condition que la viscosité intrinsèque du deuxième polyphénylène éther soit de 0,03 à 0,09 décilitre/gramme de plus que la viscosité intrinsèque du premier polyphénylène éther ; où le deuxième polyphénylène éther a un deuxième poids moléculaire moyen en poids, $M_w2$, un deuxième poids moléculaire moyen en nombre, $M_n2$, et une deuxième dispersité, $M_w2/M_n2$, déterminée conformément à la norme ASTM D5296-19 en utilisant la chromatographie par perméation de gel avec des standards de polystyrène ;
5 à 25 % en poids d'un polystyrène atactique ; et
0 à 10 % en poids d'un copolymère à blocs hydrogéné d'un composé aromatique d'alcényle et d'un diène conjugué ;
dans lequel un mélange de 40 à 90 % en poids du premier polyphénylène éther et de 5 à 25 % en poids du deuxième polyphénylène éther a un poids moléculaire moyen en poids de mélange, $M_w$blend, un poids moléculaire moyen en nombre de mélange, $M_n$blend, et une dispersité de mélange, $M_w$blend/$M_n$blend, déterminée conformément à la norme ASTM D5296-19 en utilisant la chromatographie par perméation de gel avec des standards de polystyrène ; où la dispersité de mélange, $M_w$blend, est supérieure à la première dispersité, $M_w1/M_n1$, et inférieure à la deuxième dispersité, $M_w2/M_n2$ ; et
dans lequel la somme des pourcentages en poids du premier polyphénylène éther, du deuxième polyphénylène

éther, du polystyrène atactique, et du copolymère à blocs hydrogéné est de 95 à 100 % en poids.

**2.** Article réfléchissant selon la revendication 1, dans lequel

le premier poids moléculaire moyen en poids, $M_w1$, est de 30 000 à 47 000 grammes/ mole, le premier poids moléculaire moyen en nombre, $M_n1$, est de 15 000 à 24 000 grammes/ mole, et la première dispersité, $M_w1/M_n1$, est de 2,0 à 2,45 ;
le deuxième poids moléculaire moyen en poids, $M_w2$, est supérieur à un nombre de 47 000 à 65 000 grammes/ mole, le deuxième poids moléculaire moyen en nombre, $M_n2$, est de 15 000 à 24 000 grammes/ mole, et la deuxième dispersité, $M_w2/M_n2$, est de 2,45 à 3,00 ; et
le poids moléculaire moyen en poids de mélange, $M_w$blend, est de 31 000 à 65 000 grammes/ mole, le poids moléculaire moyen en nombre de mélange, $M_n$blend, est de 13 000 à 25 000 grammes/ mole, et la dispersité de mélange, $M_w$blend/$M_n$blend, est de 2,1 à 2,55.

**3.** Article réfléchissant selon la revendication 1 ou 2, dans lequel la composition pré-mélangée comprend en outre 0,3 à 1,6 % en poids d'un acide carboxylique ou d'un anhydride d'acide carboxylique choisi dans le groupe constitué de l'acide citrique, l'acide fumarique, l'acide maléique, l'anhydride maléique, l'acide formique, et des combinaisons de ceux-ci ; dans lequel la somme des pourcentages en poids du premier polyphénylène éther, du deuxième polyphénylène éther, du polystyrène atactique, du copolymère à blocs hydrogéné, et de l'acide carboxylique ou de l'anhydride d'acide carboxylique est de 95,3 à 100 % en poids.

**4.** Article réfléchissant selon l'une quelconque des revendications 1 à 3, dans lequel l'un des premier et deuxième polyphénylène éthers comprend un poly(2,6-diméthyl-1,4-phénylène éther) et l'autre des premier et deuxième polyphénylène éthers comprend un copolymère à blocs de polyphénylène éther - polysiloxane.

**5.** Article réfléchissant selon la revendication 1, dans lequel la composition pré-mélangée comprend

65 à 75 % en poids du premier polyphénylène éther,
10 à 20 % en poids du deuxième polyphénylène éther,
10 à 20 % en poids du polystyrène atactique, et
0 à 10 % en poids du copolymère à blocs hydrogéné d'un composé aromatique d'alcényle et d'un diène conjugué ;
le premier polyphénylène éther et le deuxième polyphénylène éther comprennent chacun un poly(2,6-diméthyl-1,4-phénylène éther), ou l'un des premier et deuxième polyphénylène éthers comprend un poly(2,6-diméthyl-1,4-phénylène éther) et l'autre des premier et deuxième polyphénylène éthers comprend un copolymère à blocs de polyphénylène éther - polysiloxane ; et
la somme des pourcentages en poids du premier polyphénylène éther, du deuxième polyphénylène éther, du polystyrène atactique, et du copolymère à blocs hydrogéné est de 97 à 100 % en poids.

**6.** Article réfléchissant selon la revendication 5, dans lequel la composition pré-mélangée comprend en outre 0,3 à 1,6 % en poids d'acide citrique, sur la base du poids total de la composition pré-mélangée ; et dans lequel la somme des pourcentages en poids du premier polyphénylène éther, du deuxième polyphénylène éther, du polystyrène atactique, du copolymère à blocs hydrogéné, et de l'acide citrique est de 97,3 à 100 % en poids.

**7.** Article réfléchissant selon l'une quelconque des revendications 1 à 6 choisi dans le groupe constitué par les réflecteurs de phare avant automobiles, les enjoliveurs automobiles, les réflecteurs d'affichage tête haute automobiles, les parties intérieures automobiles, les réflecteurs d'éclairage d'électroménager, les cadrans d'électroménager, les réflecteurs d'éclairage de dispositifs électroniques grand public, et les cadrans électroniques grand public.

**8.** Article réfléchissant selon la revendication 7, où l'article réfléchissant est un réflecteur de phare avant automobile.

**9.** Composition mélangée en fusion comprenant le produit du mélange en fusion d'une composition pré-mélangée comprenant, sur la base du poids total de la composition pré-mélangée,

40 à 90 % en poids d'un premier polyphénylène éther ayant une viscosité intrinsèque de 0,3 à 0,43 décilitre/gramme, déterminée dans du chloroforme à 23°C par un viscosimètre Ubbelohde, et ayant un premier poids moléculaire moyen en poids, $M_w1$, un premier poids moléculaire moyen en nombre, $M_n1$, et une première dispersité, $M_w1/M_n1$, déterminée conformément à la norme ASTM D5296-19 en utilisant la chromatographie par perméation de gel avec des standards de polystyrène ;

5 à 25 % en poids d'un deuxième polyphénylène éther ayant une viscosité intrinsèque supérieure à 0,43 à 0,49 décilitre/gramme, déterminée dans du chloroforme à 23°C par un viscosimètre Ubbelohde ; à condition que la viscosité intrinsèque du deuxième polyphénylène éther soit de 0,03 à 0,09 décilitre/gramme de plus que la viscosité intrinsèque du premier polyphénylène éther ; où le deuxième polyphénylène éther a un deuxième poids moléculaire moyen en poids, $M_w2$, un deuxième poids moléculaire moyen en nombre, $M_n2$, et une deuxième dispersité, $M_w2/M_n2$, déterminée conformément à la norme ASTM D5296-19 en utilisant la chromatographie par perméation de gel avec des standards de polystyrène ;
5 à 25 % en poids d'un polystyrène atactique ; et
0 à 10 % en poids d'un copolymère à blocs hydrogéné d'un composé aromatique d'alcényle et d'un diène conjugué ;
dans laquelle un mélange de 40 à 90 % en poids du premier polyphénylène éther et de 5 à 25 % en poids du deuxième polyphénylène éther présente un poids moléculaire moyen en poids de mélange, $M_w$blend, un poids moléculaire moyen en nombre de mélange, $M_n$blend, et une dispersité de mélange, $M_w$blend/$M_n$blend, déterminée conformément à la norme ASTM D5296-19 en utilisant la chromatographie par perméation de gel avec des standards de polystyrène ; où la dispersité de mélange, $M_w$blend, est supérieure à la première dispersité, $M_w1/M_n1$, et inférieure à la deuxième dispersité, $M_w2/M_n2$ ; et
dans laquelle la somme des pourcentages en poids du premier polyphénylène éther, du deuxième polyphénylène éther, du polystyrène atactique, et du copolymère à blocs hydrogéné est de 95 à 100 % en poids.

**10.** Composition mélangée en fusion selon la revendication 9, où la composition pré-mélangée comprend en outre 0,3 à 1,6 % en poids d'un acide carboxylique ou d'un anhydride d'acide carboxylique choisi dans le groupe constitué de l'acide citrique, l'acide fumarique, l'acide maléique, l'anhydride maléique, l'acide formique, et des combinaisons de ceux-ci ; dans laquelle la somme des pourcentages en poids du premier polyphénylène éther, du deuxième polyphénylène éther, du polystyrène atactique, du copolymère à blocs hydrogéné, et de l'acide carboxylique ou de l'anhydride d'acide carboxylique est de 95,3 à 100 % en poids.

**11.** Composition mélangée en fusion selon la revendication 9 ou 10, dans laquelle l'un des premier et deuxième polyphénylène éthers comprend un poly(2,6-diméthyl-1,4-phénylène éther) et l'autre des premier et deuxième polyphénylène éthers comprend un copolymère à blocs de polyphénylène éther - polysiloxane.

**12.** Composition mélangée en fusion selon la revendication 9,

où la composition pré-mélangée comprend
65 à 75 % en poids du premier polyphénylène éther,
10 à 20 % en poids du deuxième polyphénylène éther,
10 à 20 % en poids du polystyrène atactique, et
0 à 10 % en poids du copolymère à blocs hydrogéné d'un composé aromatique d'alcényle et d'un diène conjugué ;
dans laquelle le premier polyphénylène éther et le deuxième polyphénylène éther comprennent chacun un poly(2,6-diméthyl-1,4-phénylène éther), ou l'un des premier et deuxième polyphénylène éthers comprend un poly(2,6-diméthyl-1,4-phénylène éther) et l'autre des premier et deuxième polyphénylène éthers comprend un copolymère à blocs de polyphénylène éther - polysiloxane ; et
la somme des pourcentages en poids du premier polyphénylène éther, du deuxième polyphénylène éther, du polystyrène atactique, et du copolymère à blocs hydrogéné est de 97 à 100 % en poids.

**13.** Composition mélangée en fusion selon la revendication 12, où la composition pré-mélangée comprend en outre 0,3 à 1,6 % en poids d'acide citrique, sur la base du poids total de la composition pré-mélangée ; et dans laquelle la somme des pourcentages en poids du premier polyphénylène éther, du deuxième polyphénylène éther, du polystyrène atactique, du copolymère à blocs hydrogéné, et de l'acide citrique est de 97,3 à 100 % en poids.

**14.** Article moulé par injection comprenant la composition mélangée en fusion selon l'une quelconque des revendications 9 à 13.

**15.** Article moulé par injection selon la revendication 14, comprenant la composition mélangée en fusion selon la revendication 12 ou 13.

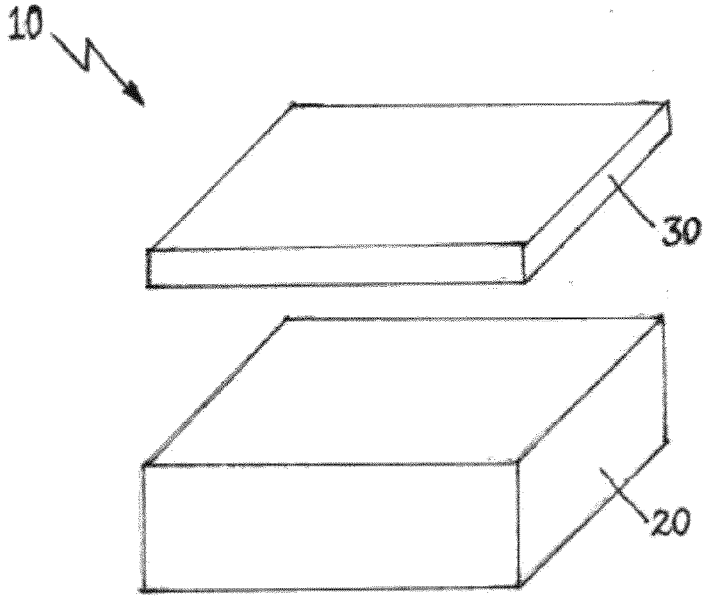


FIG.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3546509 B1
- US 8017697 B, Carrillo
- US 20120329961 A1, Carrillo